# EUROPEAN PATENT SPECIFICATION

(11) **EP 3 383 151 B1**
(45) Date of publication and mention of the grant of the patent: **09.06.2021**
(21) Application number: 17163348.0
(22) Date of filing: 28.03.2017
(51) Int. Cl.: H05K 5/06, H05K 7/20

(54) **PROTECTIVE HOUSING FOR AN ELECTRONIC MODULE AND ASSEMBLY METHOD**
SCHUTZGEHÄUSE FÜR EIN ELEKTRONISCHES MODUL UND MONTAGEVERFAHREN
BOÎTIER DE PROTECTION D'UN MODULE ÉLECTRONIQUE ET PROCÉDÉ D'ASSEMBLAGE

(43) Date of publication of application: 03.10.2018
(73) Proprietor: FRIWO Gerätebau GmbH, 48346 Ostbevern (DE)
(72) Inventor: XU, Linzhong, 48268 Greven (DE); YILMAZ, Taner, 48151 Münster (DE)
(74) Representative: Grünecker Patent- und Rechtsanwälte PartG mbB

(56) References cited:
- EP-A1- 0 489 341
- EP-B1- 2 227 929
- DE-A1-102014 104 856
- US-A- 3 584 106
- US-A- 3 778 529
- US-A1- 2012 002 381

## Description

The present invention relates to a protective housing for an electronic module and to a corresponding method of assembling a protective housing with an electronic module.

Power electronics control and convert electric power by means of electrically functional components such as solid-state electronics. It is necessary for certain applications, e.g. for powering portable devices, that the power electronics is compactly assembled. This leads, on the one hand, to the fact that the tightly packed electronics needs electrically insulating protection and, on the other hand, that the cooling concept is particularly important.

Additionally, for a potential outdoor application, the power electronics needs to be safely operated in dusty and moist environment. Here, the protection classes IP6x and IPx7 have to be observed.

As is generally known, the so-called IP code (Ingress Protection) relates to protection against solid particles and liquid ingression. A housing can be dust tight (IP6x) and provide protection against temporary submersion (IPx7) according to the Standard DIN EN 60529 [DIN EN 60529 (VDE 0470-1):2014-09 *Protection Classes by casings (IP-Code) (IEC 60529:1989* + *A1:1999* + *A2:2013); German Version EN 60529:1991* + *A1:2000* + *A2:2013.* VDE-Verlag, Berlin].

In order to seal a casing for power electronics in accordance with protection classes IPx6 and IPx7, it is known from the European patent EP 2 227 929 B1 that a cup element for accommodating an electronic unit is filled with a filling material and covered with a cooling element.

EP 0 489 341 A1 discloses an electronic module according to the preamble of the independent claim 1. In particular, it relates to a hollow body-like housing structure, which is formed by a housing and a heat sink wall. The housing has, with the exception of a front end wall for filling the encapsulate, a substantially closed shape.

The object underlying the present invention is to provide a protective housing for an electronic module and an associated manufacturing method thereof allowing, on the one hand, the observance of a protection class, which is suited for the operation in a moist and dusty area and, on the other hand, a significant reduction of manufacturing costs and complexity by providing a compactly designed housing with an improved cooling concept. This object is solved by the subject matter of the independent claims. Advantageous embodiments of the present invention are the subject matter of the dependent claims.

The present invention is based on the idea that a protective housing for an electronic module comprises a shell, which defines an inner compartment for accommodating an electrically functional component. In an advantageous embodiment the shell may be manufactured from an electrically insulating material as e.g. plastic. Thus, the shell itself insulates the electrically functional component. Furthermore, such a shell can be fabricated from a light weight material.

According to the present invention the protective housing further comprises a cooling element with a cover plate, a first side plate, and a second side plate, the first side plate and the second side plate extending from the cover plate and facing each other, thereby forming an inside surface, an outside surface, and an edge of the cooling element, wherein at least a part of said inside surface of the cooling element covers the shell to form a cover of the inner compartment.

The cooling element comprises, in addition to the cover plate, two side plates. Thus, the surface of the cooling element for radiating heat to the external is increased. Consequently, the power electronic unit can be cooled more efficiently, and thus, the lifetime of the electrically functional component can be increased.

The protective housing further comprises at least one cut-out, which is part of the cover plate, and at least one first channel forming partly the cover plate, wherein the first channel connects opposing edges of the cooling device and increases the volume of the inner compartment.

In assembled state, the protective housing has an inner compartment, which is filled through the cut-out with an electrically insulating filling material. Thus, the electrically functional component is sealed and electrically insulated. Thus, the electronic components can be packed more densely. Furthermore, the protective housing is waterproofed and not affected by external jolts, vibrations, and shocks. Advantageously, the filling material is flame retardant and meets the applicable standard regulations e.g. according to UL94 V0.

Through the channels, the inner compartment can be vented during the filling process. Thus, the filling process is improved and air pockets are avoided. Additionally, when the filling material is cured and the protective housing is assembled the void in the channels may be connected to a cooling fluid, and thus, the cooling efficiency can be further increased.

Advantageously, the protective housing further comprises a heat transfer element and a heat coupling element connected to the electrical functional component, wherein the heat transfer element connects the heat coupling element and the cooling element. Thus, the heat is transferred more efficiently from the heat generating electronic to the heat radiating cooling element.

A particularly economic way of fabricating the shell is to manufacture it by injection molding. Advantageously, the shell has a base and at least one side wall extending from the base.

According to an advantageous embodiment, the shell comprises at least one notch arranged at the outer periphery of the base, wherein at least one of the first side plate and the second side plate of the cooling element is at least partly inserted in the notch. Such a notch simplifies the mounting process.

At least one first part of a side wall of the shell may further comprise at least one first feed-through for a first cable. Additionally, at least a second part of the side wall may further comprise a second feed-through for a second cable.

According to an advantageous embodiment of the present invention, the first channel is abutting to the first side plate. Preferably, the protective housing may comprise a second channel which forms partly the cover plate, wherein the second channel connects opposing edges of the cooling device, increases the volume of the inner compartment and is abutting to the second side plate. Such abutting channels enable that the side wall at least partly extends into the first channel and/or the second channel, and thus, the assembling process is improved.

A particularly economic way of fabricating the cooling element is producing it by stamping and bending a one-piece part metal sheet. However, it is clear for a person skilled in the art that the cooling element may be manufactured by any other process, for example casting. Furthermore, the material is not limited to a metal, such as aluminum. Any material with a high thermal conductivity may be used to efficiently distribute the heat in the cooling element. Advantageously, the cooling element is coated with a layer of radiation enhancing material. Such a coating may be a black color painting or a black color lacquer. Thus, the heat dissipation rate can be increased. For a person skilled in the art it is clear that the cooling efficiency is increased by increasing the surface of the cooling element. For example, ribs formed on the cooling element and/or a coating with particles can further increase the surface, and thus, increase the heat dissipation rate.

The present invention also relates to a method of assembling an electronic module according to the independent claim 14.

Advantageously, the assembly method according to the present invention further comprises providing a heat transfer element and a heat coupling element connected to the electrical functional component, wherein the heat transfer element connects the heat coupling element and the cooling element.

The assembly method is especially advantageous as the air enclosed in the inner compartment can escape through the channels. Furthermore, air bubbles entrapped in the filling are avoided.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof, provided that they fall within the scope of the invention, which is defined by the appended claims. Further features and advantages will become apparent from the following more particular description of the various embodiments of the invention, as illustrated in the accompanying drawings, in which like references refer to like elements, and wherein:
- **Fig. 1**: is a schematic exploded view of a power electronic unit according to the present invention;
- **Fig. 2**: shows a perspective view of a mounted power electronic unit according to the present invention;
- **Fig. 3**: shows a sectional view along the line III-III of Fig. 4;
- **Fig. 4**: shows a top planar view of Fig. 2;
- **Fig. 5**: shows a sectional view along the line V-V of Fig. 3;
- **Fig. 6**: shows the detail VI of Fig. 5.

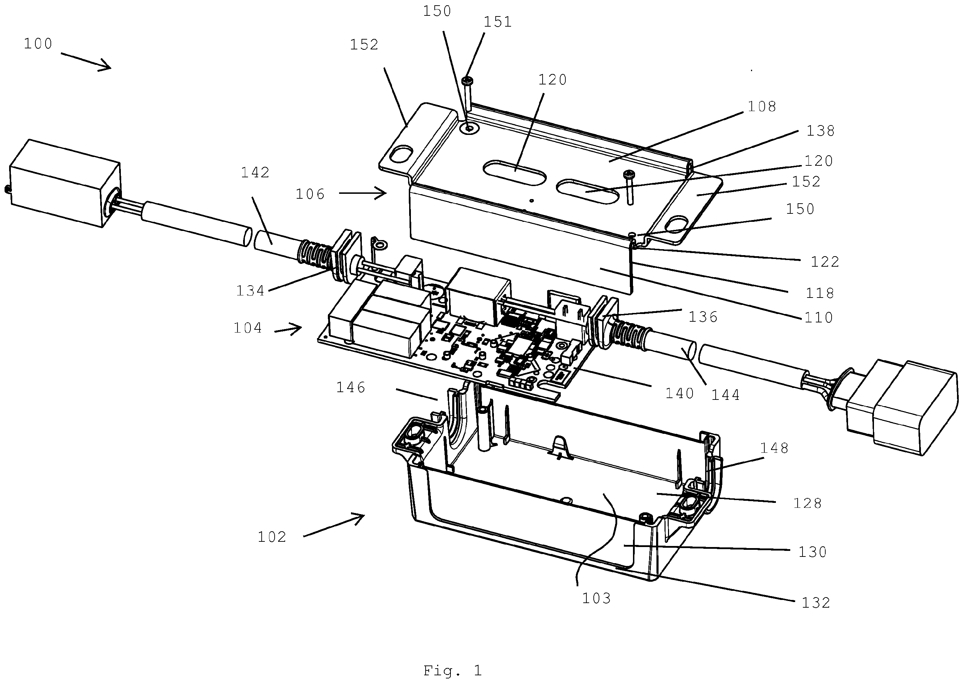

The present invention will now be explained in more detail with reference to the Figures and firstly referring to Fig. 1, which shows a schematic exploded view of a power electronic unit 100 that can benefit from the ideas according to the present invention.

The active electronic devices, such as for instance diodes and transistors, are assembled on a circuit carrier, preferably a printed circuit board (PCB) 140, to form an electrically functional component 104. The electrically functional component 104 may be any kind of power conversion system, such as a converter (e.g. DC-to-DC or AC-to-AC) or a rectifier (e.g. AC-to-DC or DC-to-AC) for converting an input power to an output power. The electrically functional component 104 comprises a primary sided input cable 142 that can be connected to an input terminal. On a secondary side, a consumer can be connected to the electrically functional component 104 via an output cable 144. Fig. 1 shows that those cables 142, 144 are provided with kink protection elements. These kink protection elements prevent the cables 142, 144 from being bent too sharply at the feed-throughs 134, 136.

According to the present invention, the electrically functional component 104 is accommodated inside a shell 102. The shell 102 advantageously is formed by injection molding as a one side open box from an electrically insulating plastic material. As shown in Fig. 1, the shell 102 may have a base 128 and a side wall 130. The base 128 has an essentially rectangular cross-section defining with the side wall 130 an inner compartment 103 for receiving the electrically functional component 104. Of course, also any other suitable cross-section, e.g. a circular, elliptical, or any other polygonal cross-section, can be chosen for the base 128. Advantageously, the shell 102 forms an almost completely closed one side open box with the first and second opening 146, 148 at its first and second end.

These openings 146, 148 are closed by means of plugs comprising the first and second feed-through 134, 136 attached to the electrically functional component 104. The first and second feed-through 134, 136 comprises the input and output cable 142, 144. Furthermore, each plug may have an outline shape that fits into the openings 146, 148. In the embodiment shown in Fig. 1, the plug is formed from an electrically insulating, flexible, preferably plastic material and has the shape of a one-sided rounded rectangle. Advantageously, the plug provides a kink protection element. Of course, also any other suitable cross-section, e.g. a circular, elliptical, or any other polygon cross-section, can be chosen for the plug. Advantageously, the plug has a notch for partly receiving the side wall 130.

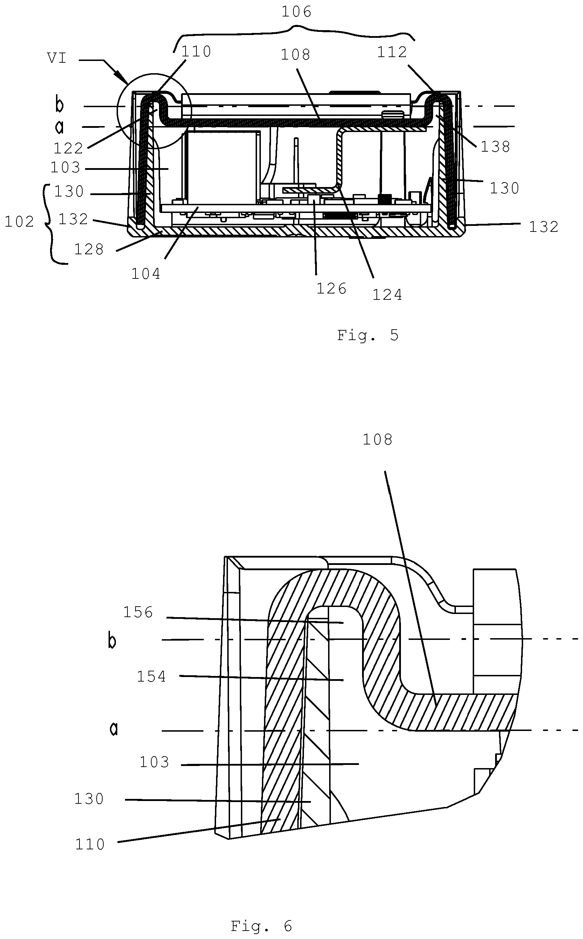

As will become more apparent from Fig. 5, the shell 102 further encompasses notches 132. As shown in Fig. 1, the notches 132 are arranged at the outer periphery of the shell 102. Advantageously, the notches 132 extend along the edges of the base 128 and the side walls 130. These notches 132 are for attaching the side plates 110, 112 of the cooling element 106 to the shell 102.

The cooling element 106 forms a cover for the shell 102. It is advantageously produced by stamping and bending a one piece part metal sheet. As shown in Fig. 1, the cooling element 106 has a U-shaped cross-section with a cover plate 108, a first side plate 110, and a second side plate 112 (hidden in Fig. 1). The cooling element 106 is advantageously made of a light weight material with a high thermal conductivity as for example aluminum. Not shown in Fig. 1 is that the cooling element 106 may further comprise a coating, which increases the thermal radiation power of the cooling element 106. Such a coating may for example be any black colored painting or black colored lacquer.

At the edge between the cover plate 108 and the side plate 110, 112 the cooling element 106 according to the present invention form two channels 122, 138. As shown in Fig. 1 the channels 122, 138 connect opposing edges of the cover plate 108. As will become more apparent from Fig. 5 and Fig. 6, the channels 122, 138 are bulges in the cover plate with one side of the channels 122, 138 being formed by the side plate 110, 112 of the cooling element 106. Of course, the present invention is not limited to two channels. Also a single channel or any other number of channels may be formed in the cover plate 108 to connect opposing edges 118 of the cover plate 108. Also, the channels need not necessarily be parallel to the side plates 110, 112. For example, the channel can form a diagonal connection in the cover plate 108.

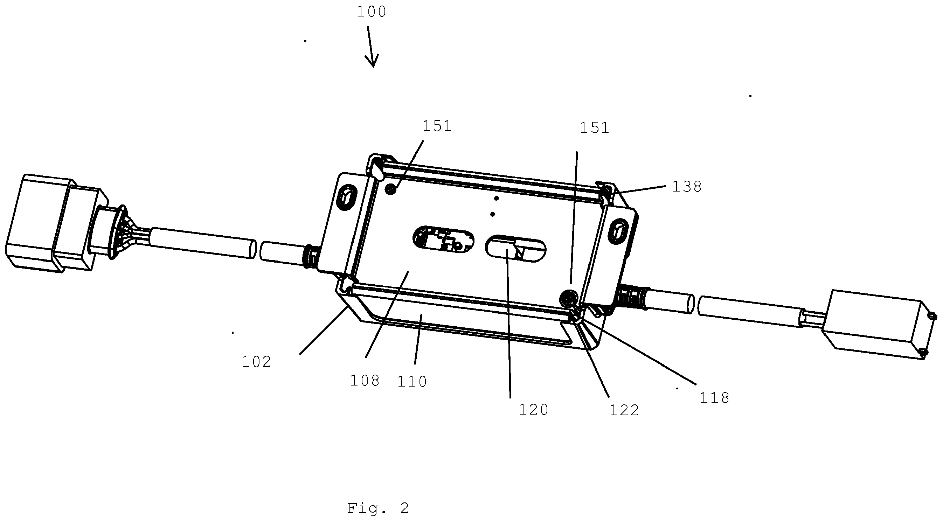

The cover plate 108 has at least one, and preferably two, cut-outs 120. The assembled protective housing 100, as shown for example in Fig. 2, is filled through the cut-outs 120 with the filling material.

As shown in Fig. 1, the cover plate 108 according to one embodiment of the present invention comprises holes 150 for fastening means. Additionally, fastening plates 152 may be attached to the cover plate 108 for mechanically attaching the cover plate 108 to the side wall 130 of the shell 102.

The assembled construction of the power electronic unit 100 according to the present invention becomes more apparent from the perspective view in Fig. 2. The cooling element 106 covers the shell 102. The end regions of the first side plate 110 and the second side plate 112 (hidden in Fig. 2) are received in the notches 132 of the shell 102 and preferably clamped with the shell 102. Additionally or alternatively, the cooling element 106 is attached to the base 128 of shell 102 by fastening means 151 through the cover plate 108. The fastening plates 152 of the cooling element 106 may, for example adhesively, be attached to the side wall 130 of the shell 102.

The side plates 110, 112 of the cooling element 106, which are made of a material with high thermal conductivity, cover the side wall 130 of the shell 102, which is made of an electrically insulating material. The side plates 110, 112 are thermally connected to the cover plate 108, and thus, the surface for heat dissipation of the cooling element 106 is increased. Consequently, the power electronic unit 100 can be cooled by the cooling element 106 more efficiently.

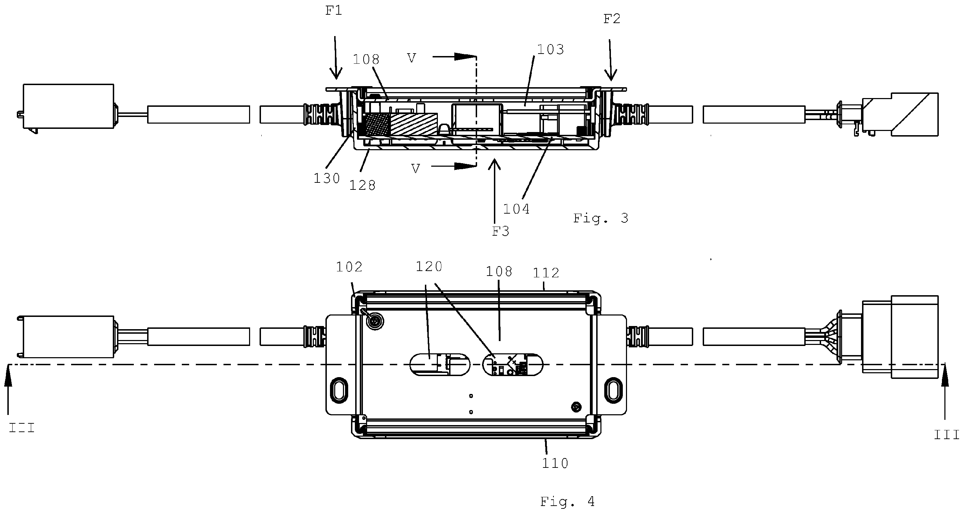

Fig. 4 shows a top view of the assembled power electronic unit 100 and Fig. 3 shows a cross section thereof. In the assembled state the electrically functional component 104 is placed on the base 128 of the shell 102. The shell 102 is covered by the cover plate 108 of the cooling element 106. The remaining inner compartment 103 is filled with an electrically insulating filling material through the cut-outs 120. Preferably, the filling material is formed by an electrically insulating, flame protective casting resin. The filling material may comprise any suitable casting resin, for instance an epoxy resin or a silicon material.

Fig. 5 shows a second cross-section of the assembled power electronic unit 100. The shell 102 according to the present invention comprises a sidewall 130 extending from the base 128. At the outer periphery the base 128 of the shell 102 comprises notches 132. The side plates 110, 112 of the cooling element 106 are partly inserted into the notches 132. The side wall 130 of the shell 102 is partly inserted into the channels 122, 138 formed in the cooling element 106.

According to one advantageous embodiment of the present invention, the electrically functional component 104 comprises a heat coupling element 126. The heat coupling element 126 is connected thermally to the cooling element 106 by a heat transfer element 124. The heat transfer element 124 is made of a material with high thermal conductivity, for example a metal as aluminum. Generally, the thermal conductivity of the heat transfer element 124 is higher than the thermal conductivity of the filling material and the thermal conductivity of the shell 102. Thus, heat generated by the electrically functional component 104 can be transported efficiently to the cooling element 106, efficiently distributed in the cooling element 106, which advantageously is also made of a material with a high thermal conductivity, and efficiently dissipated to the exterior from the cooling element 106, which advantageously has a coating layer of radiation enhancing material.

Fig. 6 shows a detail of Fig. 5. Two dashed-dotted lines indicate the filling levels a and b. These filling levels and the inner surface of the channel 122 limit the lower channel space 154 and the upper channel space 156. In assembled state, the inner compartment 103 of the power electronic unit 100 is filled with a filling material leaving a void 154, 156 in the channels 122, 138. This corresponds in Fig. 5 and Fig. 6 to the filling level a.

In an alternative embodiment, in addition to the inner compartment 103, the channels 122, 138 are partly filled with filling material. This corresponds in Fig. 5 and Fig. 6 to the filling level b. A void 156 is left in the channel 122, 138.

With reference to Figs. 1 to 6, the procedure for assembling a power electronic unit 100 according to the present invention will be explained in the following.

In a first step, a printed circuit board (PCB) 140 is assembled with electronic components for converting or controlling electrical power to form a transformer unit 104. A shell 102, which has advantageously a base 128 and extending there from at least one side wall 130, is fabricated preferably by injection molding from an electrically insulating plastic material. The side wall 130 of the shell 102 may further comprise at least one opening for receiving at least one feed-through.

Next, at least one feed-through 134, 136 with preferably a plug is assembled at the transformer unit 104. The feed-through 134, 136 comprises a cable 142, 144, which is connected to the PCB. The transformer unit 104 is inserted in the shell 102 and connected to the electrically insulating base 128. Preferably, the plug forms a part of the side wall 130 so that the shell 102 has essentially the geometry of a one-side open box.

In a next step, the cooling element 106, which preferably is fabricated by stamping and bending a one-pieced metal sheet, is attached to the shell 102 forming an inner compartment 103.

In a preferred embodiment a heat transfer element 124 is inserted and attached to the heat coupling element 126 and the cooling element 106. For example, the heat transfer element 124 is clamped, soldered, or bonded to the heat coupling element 126 and the cooling element 106.

In one embodiment the cover plate 108 of the cooling element 106 is attached to the base 128 of the shell 102 by fastening means 151, for example a screw. Additionally or alternatively, at least one fastening plate 152 is connected to the cover plate 108. The fastening plate 152 can be attached, for example adhesively or by fastening means, to the side wall 130 of the shell 102.

In a final step, a filling material is filled into the inner compartment 103 through cut-outs 120. The dash-dotted line a in Fig. 5 and Fig. 6 indicates the filling level. The air enclosed in the inner compartment 103 escapes via the channels 122, 138. When the filling material is cured the inner compartment 103 is sealed with an electrically insulating material leaving a void 154, 156 in the channels 122, 138. Thus, the transformer unit 104 is sealed and mechanically fixed to the shell 102.

In one alternative embodiment, without fastening means, the power electronic unit 100 is clamped during the final filling step. The cooling element 106 is attached to the shell 102. As shown with reference to Fig. 3 forces F1 and F2 are applied to the fastening plates 152 and force F3 is applied to the base 128 in an opposing direction to the forces F1 and F2. Thus, the shell 102 and the cooling element 106 are clamped.

Alternatively or additionally, at least one side plate 110, 112 of the cooling device 106 partly extends into at least one notch 132 formed at the outer periphery of the base 128. Preferably, the cooling device 106 is thus clamped to the shell 102.

Finally, the filling material is filled into the inner compartment 103 through cut-outs 120. The dash-dotted line b in Fig. 5 and Fig. 6 indicates the filling level. The air enclosed in the inner compartment 103 escapes via the channels 122, 138. When the filling material is cured the inner compartment 103 and part of the channels 122, 138 are sealed with an electrically insulating material leaving a void 156 in the channels 122, 138. Even if the forces F1, F2, and F3 are no longer applied the cured filling material adhesively connects the cooling element 106 to the shell 102. Thus, additional fastening can be avoided. However, for a person skilled in the art it is clear that fastening means, as described above, can be used in addition. Thus, the stability of the assembled power electronic unit 100 might be increased.

The power electronic unit according to the present invention is sealed against water and dust, and thus, meets the requirements of IP67 and all relevant electric safety standards. Moreover, the electrically functional components can be densely packed and the generated heat is dissipated efficiently by the inventive housing. This is advantageous in view of robustness, weight, and vibration characteristics.

Although in the above figures only an embodiment is shown wherein the power electric unit has a rectangular geometry, it is clear to a person skilled in the art that the concept according to the present invention may also be used when providing any other geometry for the housing. Furthermore, the above shown feed-throughs may be differently arranged.

**Reference Numerals**

| **Reference Numerals** | **Description** |
|---|---|
| 100 | power electronic unit |
| 102 | shell |
| 103 | inner compartment |
| 104 | electrically functional component |
| 106 | cooling element |
| 108 | cover plate |
| 110 | first side plate |
| 112 | second side plate |
| 118 | edge |
| 120 | cut-out |
| 122 | first channel |
| 124 | heat transfer element |
| 126 | heat coupling element |
| 128 | base |
| 130 | side wall |
| 132 | notch |
| 134 | first feed-through |
| 136 | second feed-through |
| 138 | second channel |
| 140 | printed circuit board |
| 142 | first cable |
| 144 | second cable |
| 146 | first shell opening |
| 148 | second shell opening |
| 150 | holes |
| 151 | fastening means |
| 152 | fastening plates |
| 154 | lower channel space |
| 156 | upper channel space |

## Claims

1. Electronic module (100) comprising a protective housing, the protective housing comprising:
a shell (102) which defines an inner compartment (103) for accommodating an electrically functional component (104),
a cooling element (106) comprising a cover plate (108), a first side plate (110), and a second side plate (112), the first side plate (110) and second side plate (112) extending from the cover plate (108) and facing each other, thereby forming an inside surface, an outside surface, and an edge (118) of the cooling element,
wherein at least a part of said inside surface of the cooling element (106) covers the shell (102) to form a cover of the inner compartment (103),
at least one cut-out (120) which is part of the cover plate (108) for filling the inner compartment (103) with an electrically insulating material,
at least one first channel (122) forming partly the cover plate (108), wherein the channel (122) is formed as a bulge in the cover plate with one side of the channel being formed by the side plate (110, 112) of the cooling element (106) and wherein the channel is configured so as to increase the volume of the inner compartment (103), and
wherein the inner compartment (103) of the electronic module (100) is filled with an electrically insulating filling material
**characterized in that:**
the electronic module is configured so that when the filling material is cured a void (154, 156) is left in at least a part of said first channel (122).

2. Electronic module according to claim 1, further comprising a heat transfer element (124) and a heat coupling element (126) connected to the electrical functional component (104), wherein the heat transfer element (124) connects the heat coupling element (126) and the cooling element (106).

3. Electronic module according to claim 1 or 2, wherein the shell (102) has a base (128) and at least one side wall (130) extending from the base (128).

4. Electronic module according to claim 3, further comprising at least one notch (132) arranged at the outer periphery of the base (128), wherein at least one of the first side plate (110) and the second side (112) plate is at least partly inserted in the notch (132).

5. Electronic module according to claim 3 or 4, wherein at least a part of said side wall (130) further comprises at least one first feed-through (134) for connecting a first cable (142).

6. Electronic module according to claim 5, wherein at least a part of the said side wall (130) further comprises a second feed-through (136) for a second cable (144).

7. Electronic module according to one of the proceeding claims, wherein the first channel (122) is abutting to the first side plate (110).

8. Electronic module according to one of the proceeding claims, further comprising a second channel (138) which forms partly the cover plate (108), wherein the second channel (138) connects opposing edges (118) of the cooling element (106), increases the volume of the inner compartment (103) and is abutting to the second side plate (112).

9. Electronic module according to claim 7 or 8, wherein the side wall (130) at least partly extends into the first channel (122) and/or the second channel (138).

10. Electronic module according to one of the proceeding claims, wherein the cooling element (106) is made of a material with high thermal conductivity.

11. Electronic module according to one of the proceeding claims, wherein the cooling element (106) is coated with a layer of radiation enhancing material.

12. Electronic module according to one of the proceeding claims, wherein the cooling element (106) is produced by stamping and bending a one-piece part metal sheet.

13. Electronic module according to one of the proceeding claims, wherein the shell (102) is produced by injection molding form an electrically insulating material.

14. Method of assembling an electronic module, comprising the following steps:
providing a shell (102) which defines an inner compartment (103) for accommodating an electrically functional component (104),
inserting the functional component (104) in said inner compartment (103),
providing a cooling element (106) comprising a cover plate (108), a first side plate (110), and a second side plate (112), the first side plate (110) and second side plate (112) extending from the cover plate (108) and facing each other, thereby forming an inside surface, an outside surface, and an edge (118) of the cooling element,
covering the shell (102) with at least a part of said inside surface of the cooling element (106) to form a cover of the inner compartment (103),
cutting out at least a part of the cover plate (108) for filling the inner compartment,
forming at least one first channel (122) in the cover plate (108), wherein the channel (122) is formed as a bulge in the cover plate with one side of the channel being formed by the side plate (110, 112) of the cooling element (106) and wherein the channel is configured so as to increase the volume of the inner compartment (103), and
filling the inner compartment (103) of the electronic module (100) with an electrically insulating filling material;
**characterized by:**
curing the electrically insulating filling material so that when the filling material is cured a void is left in at least a part of said first channel (122).

15. Method according to claim 14, further providing heat transfer element (124) and a heat coupling element (126) connected to the electrical functional component (104), wherein the heat transfer element (124) connects the heat coupling element (126) and the cooling element (106).

## Patentansprüche

1. Elektronisches Modul (100) mit einem Schutzgehäuse, wobei das Schutzgehäuse umfasst:
ein Schalenelement (102), das einen Innenraum (103) zur Aufnahme eines elektrischen Bauteils (104) definiert,
ein Kühlelement (106), das eine Abdeckplatte (108), eine erste Seitenplatte (110) und eine zweite Seitenplatte (112) umfasst, wobei sich die erste Seitenplatte (110) und die zweite Seitenplatte (112) von der Abdeckplatte (108) aus erstrecken und einander zugewandt sind, wodurch eine Innenfläche, eine Außenfläche und einen Rand (118) des Kühlelements gebildet werden,
wobei zumindest ein Teil der Innenfläche des Kühlelements (106) das Schalenelement (102) bedeckt, um eine Abdeckung des Innenraums (103) zu bilden,
mindestens eine Ausschneidung (120), die Teil der Abdeckplatte (108) ist, wodurch der Innenraum (103) mit einem elektrisch isolierenden Material gefüllt werden kann,
mindestens einen ersten Kanal (122), der einen Teil der Abdeckplatte (108) bildet, wobei der Kanal (122) als Ausbuchtung in der Abdeckplatte ausgebildet ist, wobei eine Seite des Kanals durch die Seitenplatte (110, 112) des Kühlelements (106) gebildet wird und wobei der Kanal so gestaltet ist, dass er das Volumen des Innenraums (103) vergrößert, und
wobei der Innenraum (103) des elektronischen Moduls (100) mit einem elektrisch isolierenden Füllmaterial gefüllt ist;
**dadurch gekennzeichnet, dass**
das elektronische Modul so konfiguriert ist, dass, wenn das Füllmaterial ausgehärtet ist, ein Hohlraum (154, 156) in zumindest einem Teil des ersten Kanals (122) zurückbleibt.

2. Elektronisches Modul nach Anspruch 1, ferner umfassend ein Wärmeübertragungselement (124) und ein Wärmekopplungselement (126), das mit dem elektrischen Bauteil (104) verbunden ist, wobei das Wärmeübertragungselement (124) das Wärmekopplungselement (126) und das Kühlelement (106) verbindet.

3. Elektronisches Modul nach Anspruch 1 oder 2, wobei das Schalenelement (102) einen Boden (128) und mindestens eine vom Boden (128) ausgehende Seitenwand (130) aufweist.

4. Elektronisches Modul nach Anspruch 3, ferner umfassend mindestens eine am Außenumfang des Bodens (128) angeordnete Kerbe (132), wobei mindestens eine der ersten Seitenplatte (110) und der zweiten Seitenplatte (112) zumindest teilweise in die Kerbe (132) eingesetzt ist.

5. Elektronisches Modul nach Anspruch 3 oder 4, wobei mindestens ein Teil der Seitenwand (130) weiterhin mindestens eine erste Durchführung (134) zum Anschluss eines ersten Kabels (142) aufweist.

6. Elektronisches Modul nach Anspruch 5, wobei zumindest ein Teil der Seitenwand (130) weiterhin eine zweite Durchführung (136) für ein zweites Kabel (144) aufweist.

7. Elektronisches Modul nach einem der vorhergehenden Ansprüche, wobei der erste Kanal (122) an der ersten Seitenplatte (110) anliegt.

8. Elektronisches Modul nach einem der vorhergehenden Ansprüche, ferner umfassend einen zweiten Kanal (138), der einen Teil der Deckplatte (108) bildet, wobei der zweite Kanal (138) gegenüberliegende Ränder (118) des Kühlelements (106) verbindet, das Volumen des Innenraums (103) vergrößert und an der zweiten Seitenplatte (112) anliegt.

9. Elektronikmodul nach Anspruch 7 oder 8, wobei die Seitenwand (130) zumindest teilweise in den ersten Kanal (122) und/oder den zweiten Kanal (138) hineinragt.

10. Elektronisches Modul nach einem der vorhergehenden Ansprüche, wobei das Kühlelement (106) aus einem Material mit hoher Wärmeleitfähigkeit besteht.

11. Elektronisches Modul nach einem der vorangehenden Ansprüche, wobei das Kühlelement (106) mit einer Schicht aus einem Material beschichtet ist, wobei das Material die Wärmeabstrahlung verbessert.

12. Elektronisches Modul nach einem der vorangehenden Ansprüche, wobei das Kühlelement (106) durch Stanzen und Biegen eines einteiligen Metallteils hergestellt ist.

13. Elektronikmodul nach einem der vorangehenden Ansprüche, wobei das Schalenelement (102) durch Spritzgießen aus einem elektrisch isolierenden Material hergestellt ist.

14. Verfahren zum Zusammenbau eines elektronischen Moduls, mit den folgenden Schritten:
Bereitstellen eines Schalenelements (102), das einen Innenraum (103) zur Aufnahme eines elektrischen Bauteils (104) definiert,
Einsetzen des elektrischen Bauteils (104) in den Innenraum (103),
Bereitstellen eines Kühlelements (106), das eine Abdeckplatte (108), eine erste Seitenplatte (110) und eine zweite Seitenplatte (112) umfasst, wobei sich die erste Seitenplatte (110) und die zweite Seitenplatte (112) von der Abdeckplatte (108) aus erstrecken und einander zugewandt sind, wodurch eine Innenfläche, eine Außenfläche und ein Rand (118) des Kühlelements gebildet werden,
Abdecken des Schalenelements (102) mit mindestens einem Teil der Innenfläche des Kühlelements (106), um eine Abdeckung des Innenraums (103) zu bilden,
Ausschneiden mindestens eines Teils der Abdeckplatte (108), um einen Zugang zum Füllen des Innenraums bereitzustellen,
Ausbilden mindestens eines ersten Kanals (122) in der Abdeckplatte (108), wobei der Kanal (122) als eine Ausbuchtung in der Abdeckplatte ausgebildet ist, wobei eine Seite des Kanals durch die Seitenplatte (110, 112) des Kühlelements (106) gebildet wird und wobei der Kanal so konfiguriert ist, dass er das Volumen des Innenraums (103) vergrößert, und
Füllen des Innenraums (103) des elektronischen Moduls (100) mit einem elektrisch isolierenden Füllmaterial;
**gekennzeichnet durch**:
Aushärten des elektrisch isolierenden Füllmaterials, so dass, wenn das Füllmaterial ausgehärtet ist, ein Hohlraum in mindestens einem Teil des ersten Kanals (122) zurückbleibt.

15. Verfahren nach Anspruch 14, ferner Bereitstellen eines Wärmeübertragungselements (124) und eines Wärmekopplungselements (126), das mit dem elektrischen Funktionsbauteil (104) verbunden ist, wobei das Wärmeübertragungselement (124) das Wärmekopplungselement (126) und das Kühlelement (106) verbindet.

## Revendications

1. Module électronique (100) comprenant un boîtier protecteur, le boîtier protecteur comprenant :
une coque (102) qui définit un compartiment interne (103) pour recevoir un composant électriquement fonctionnel (104),
un élément de refroidissement (106) comprenant une plaque de recouvrement (108), une première plaque latérale (110) et une deuxième plaque latérale (112), la première plaque latérale (110) et la deuxième plaque latérale (112) s'étendant depuis la plaque de recouvrement (108) et se faisant face, formant ainsi une surface intérieure, une surface extérieure et un bord (118) de l'élément de refroidissement,
dans lequel au moins une partie de ladite surface intérieure de l'élément de refroidissement (106) couvre la coque (102) pour former un couvercle du compartiment interne (103),
au moins une découpe (120) qui fait partie de la plaque de recouvrement (108) pour remplir le compartiment interne (103) d'un matériau électriquement isolant,
au moins un premier canal (122) formant partiellement la plaque de recouvrement (108), où le canal (122) est formé comme un renflement dans la plaque de recouvrement avec un côté du canal formé par la plaque latérale (110, 112) de l'élément de refroidissement (106) et où le canal est configuré de manière à augmenter le volume du compartiment interne (103), et
dans lequel le compartiment interne (103) du module électronique (100) est rempli d'un matériau de remplissage électriquement isolant
**caractérisé en ce que** :
le module électronique est configuré de sorte que, lorsque le matériau de remplissage est durci, un vide (154, 156) soit laissé dans au moins une partie dudit premier canal (122).

2. Module électronique selon la revendication 1, comprenant en outre un élément de transfert thermique (124) et un élément de couplage thermique (126) relié au composant fonctionnel électrique (104), où l'élément de transfert thermique (124) relie l'élément de couplage thermique (126) et l'élément de refroidissement (106).

3. Module électronique selon la revendication 1 ou 2, dans lequel la coque (102) a une base (128) et au moins une paroi latérale (130) s'étendant depuis la base (128).

4. Module électronique selon la revendication 3, comprenant en outre au moins une encoche (132) agencée au niveau de la périphérie externe de la base (128), où au moins l'une de la première plaque latérale (110) et de la deuxième plaque latérale (112) est au moins partiellement insérée dans l'encoche (132).

5. Module électronique selon la revendication 3 ou 4, dans lequel au moins une partie de ladite paroi latérale (130) comprend en outre au moins une première traversée (134) pour relier un premier câble (142).

6. Module électronique selon la revendication 5, dans lequel au moins une partie de ladite paroi latérale (130) comprend en outre une deuxième traversée (136) pour un deuxième câble (144).

7. Module électronique selon l'une des revendications précédentes, dans lequel le premier canal (122) est en butée contre la première plaque latérale (110).

8. Module électronique selon l'une des revendications précédentes, comprenant en outre un deuxième canal (138) qui forme partiellement la plaque de recouvrement (108), où le deuxième canal (138) relie des bords opposés (118) de l'élément de refroidissement (106), augmente le volume du compartiment interne (103) et est en butée contre la deuxième plaque latérale (112).

9. Module électronique selon la revendication 7 ou 8, dans lequel la paroi latérale (130) s'étend au moins partiellement dans le premier canal (122) et/ou le deuxième canal (138).

10. Module électronique selon l'une des revendications précédentes, dans lequel l'élément de refroidissement (106) est réalisé en un matériau ayant une conductivité thermique élevée.

11. Module électronique selon l'une des revendications précédentes, dans lequel l'élément de refroidissement (106) est revêtu d'une couche de matériau d'amélioration de rayonnement.

12. Module électronique selon l'une des revendications précédentes, dans lequel l'élément de refroidissement (106) est produit par estampage et pliage d'une feuille métallique monobloc.

13. Module électronique selon l'une des revendications précédentes, dans lequel la coque (102) est produite par moulage par injection à partir d'un matériau électriquement isolant.

14. Procédé d'assemblage d'un module électronique, comprenant les étapes suivantes :
fournir une coque (102) qui définit un compartiment interne (103) pour recevoir un composant électriquement fonctionnel (104),
insérer le composant fonctionnel (104) dans ledit compartiment interne (103),
fournir un élément de refroidissement (106) comprenant une plaque de recouvrement (108), une première plaque latérale (110) et une deuxième plaque latérale (112), la première plaque latérale (110) et la deuxième plaque latérale (112) s'étendant depuis la plaque de recouvrement (108) et se faisant face, formant ainsi une surface intérieure, une surface extérieure et un bord (118) de l'élément de refroidissement,
couvrir la coque (102) d'au moins une partie de ladite surface intérieure de l'élément de refroidissement (106) pour former un couvercle du compartiment interne (103),
découper au moins une partie de la plaque de recouvrement (108) pour remplir le compartiment interne,
former au moins un premier canal (122) dans la plaque de recouvrement (108), où le canal (122) est formé comme un renflement dans la plaque de recouvrement avec un côté du canal formé par la plaque latérale (110, 112) de l'élément de refroidissement (106) et où le canal est configuré de manière à augmenter le volume du compartiment interne (103), et
remplir le compartiment interne (103) du module électronique (100) d'un matériau de remplissage électriquement isolant ;
**caractérisé par** :
le durcissement du matériau de remplissage électriquement isolant de sorte que, lorsque le matériau de remplissage est durci, un vide soit laissé dans au moins une partie dudit premier canal (122).

15. Procédé selon la revendication 14, dans lequel on prévoit en outre un élément de transfert thermique (124) et un élément de couplage thermique (126) relié au composant fonctionnel électrique (104), où l'élément de transfert thermique (124) relie l'élément de couplage thermique (126) et l'élément de refroidissement (106).
